# EUROPEAN PATENT APPLICATION

(11) **EP 0 704 365 A2**
(43) Date of publication of application: **03.04.1996**
(21) Application number: 95115037.4
(22) Date of filing: 25.09.1995
(51) Int. Cl.: B61L 7/08

(54) **A diagnostic system for railway signalling apparatus**

(30) Priority: 26.09.1994 IT TO940746
(71) Applicant: TEKFER S.a.s. di Ing. Piero Montanari, I-10043 Orbassano (Torino) (IT)
(72) Inventor: Montanari, Piero, c/o Tekfer S.a.s., I-10043 Orbassano (IT)
(74) Representative: Quinterno, Giuseppe

(57) **Abstract**

A remote signalling system for diagnosing faults in the relation lines (LA) for sensor boxes (GI) positioned along railway sections, comprising computerised modules (EC, ES) positioned in the sensor boxes (GI) and in the stations (A, B)and provided with measurement instruments connected to the line (LA). The identification of faults on the line (LA) occurs in a speedy and efficient manner by automatic procedures for localisation of the fault thereby eliminating downtime due to faults and significantly simplifying the work of the maintenance team.

## Description

The present invention relates generally to diagnostic systems for railway signalling apparatus, and more specifically relates to a diagnostic system for the communication lines of signalling devices located along sections of railway.

In some countries, signalling and detection devices for the railway traffic are located along the railway lines and operable to allow an efficient and safe management thereof. These devices include electrical apparatus typically situated alongside the railway track close to the rails, and normally located in containers or cabins called sensor boxes. Hereinafter in the present specification the overall arrangement of such devices and/or apparatus contained within the said cabins, as well as to the cabins themselves, will be referred to as a sensor box.

The sensor boxes are disposed at a spacing of the order of a kilometre along the railway sections. The sensor boxes situated in a given section, that is to say a portion of railway line between two stations, are typically supplied at a medium voltage, for example a thousand volts from an electric line situated alongside the railway track. Moreover, the sensor boxes are connected, and therefore communicate with one another via electrical conductors also located alongside the railway track. These electrical conductors are typically called relay cables and allow the exchange of information between the sensor boxes.

It is not infrequently the case that faults occur which prejudice the exchange of information by means of the said relay cables. If such a fault occurs its identification and subsequent repair, effected manually, is time consuming and difficult.

Moreover, until the fault is repaired the railway traffic is obstructed. For example, current railway regulations of the Italian State in fact provide that, if a fault is detected a "fault block" is instituted in a station by sending a sound recording to the preceding station. This latter station ranges to increase the distance between trains by installing a "telephone block" equivalent to sending only one train at a time into the section, waiting to send the successive train until the preceding train has left the station, utilising telephone communications.

If, on the other hand, a fault occurs whilst a train is in transit on the section the trackside system detects the absence of the sensor box signal and in this way detects a fault (the train is braked as an emergency) and proceeds towards the station at a "visibility speed" equivalent to twenty kilometres per hour. In this case, too, the "fault block" is naturally immediately installed.

For a better understanding a prior art system will now be described with reference to Figure 1. Along a railway section lying between two stations A and B there is disposed a plurality of sensor boxes G1, G2, G3,...,GN (hereinafter the totality of the sensor boxes, or a generic sensor box, will be indicated GI). The sensor boxes GI are connected together by the said relay cables LA. Normally these relay cables LA are disposed in pairs. This can be seen, for example, in Figures 3 and 4, which will be described hereinbelow, in which are shown, by way of illustration, two pairs W1, W2 of relay cables LA. It is intended that the pairs of cables may be grouped in numbers other than two, and this may differ from system to system.

Typically, there are also present, still alongside the railway line, low voltage conductors LC which connect the two stations A, B. These conductors LC can, for example, be the conductors used for signalling the presence of a train on the line or else the conductors of a possible communication line between stations A and B.

The procedure adopted according to the prior art when a fault occurs in the relay cables LA will now be analysed.

Faults which can occur are substantially as follows:
- interruption of a conductor,
- increase in terminal contact resistance,
- leakage or short circuit between two conductors (belonging to one pair),
- leakage or short circuit between a conductor and earth.

The system according to the invention has been developed principally for diagnosing faults due to leakages and short circuits in that these are more frequent and more difficult to identify.

When a fault occurs, as already mentioned, a repair team is sent out to investigate manually the sensor boxes GI and the relay cables LA alongside the section of track by performing necessary tests for identification of the fault. As will be appreciated this procedure is extremely costly in terms of time.

The object for the present invention is to provide a diagnostic system which allows all the above indicated problems to be resolved in a satisfactory manner.

According to the present invention, this object is achieved by a system having the characteristics indicated in the claims following the present description.

Further advantages and characteristics of the present invention will become apparent from the following detailed description, given with the aid of the attached drawings, provided purely by way of non-limitative example, in which:

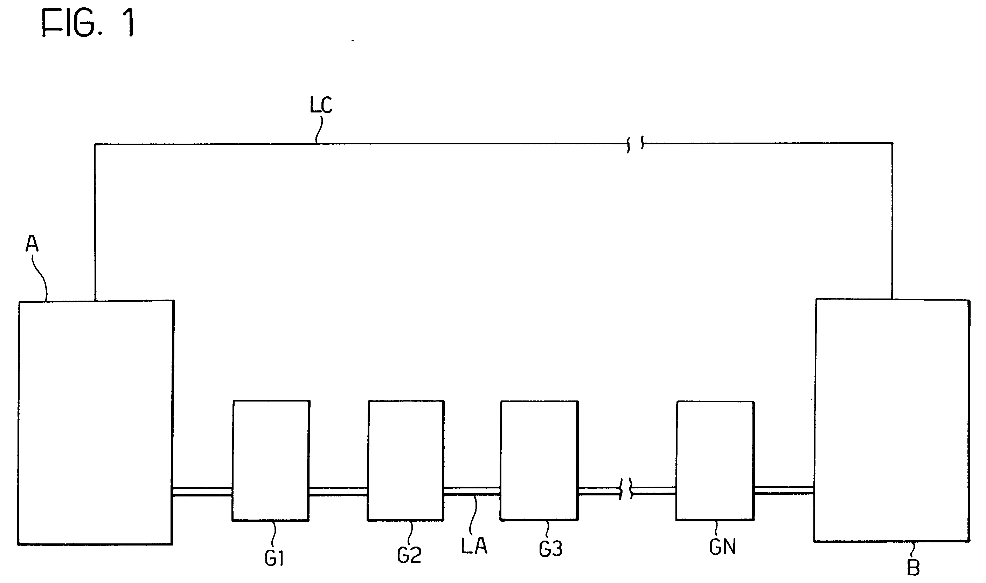

Figure 1 is a block schematic representation of a prior art railway signalling system and has already been described,

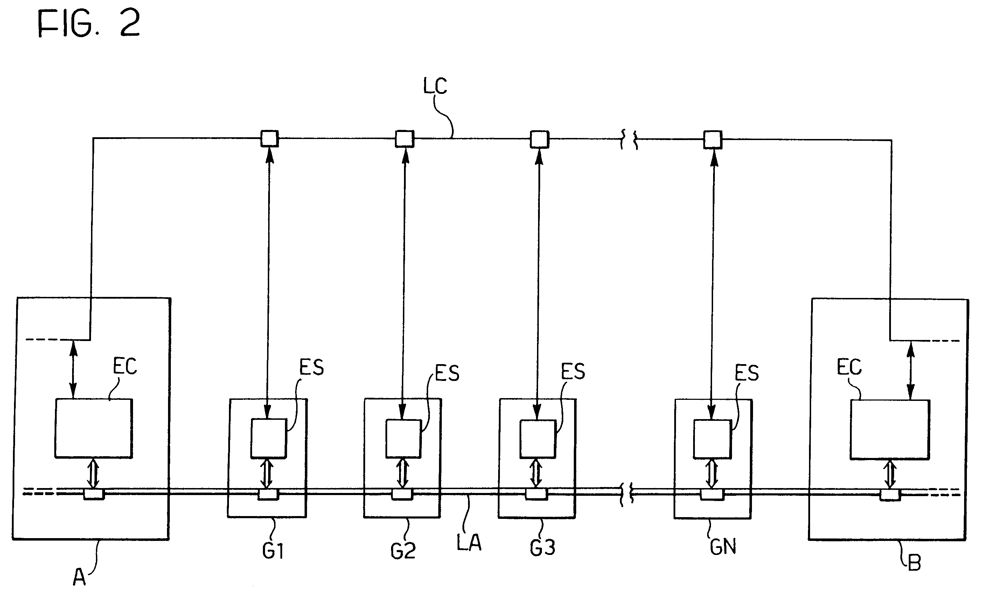

Figure 2 is a block schematic representation of a system of the type shown in Figure 1 provided with a diagnostic system according to the present invention;

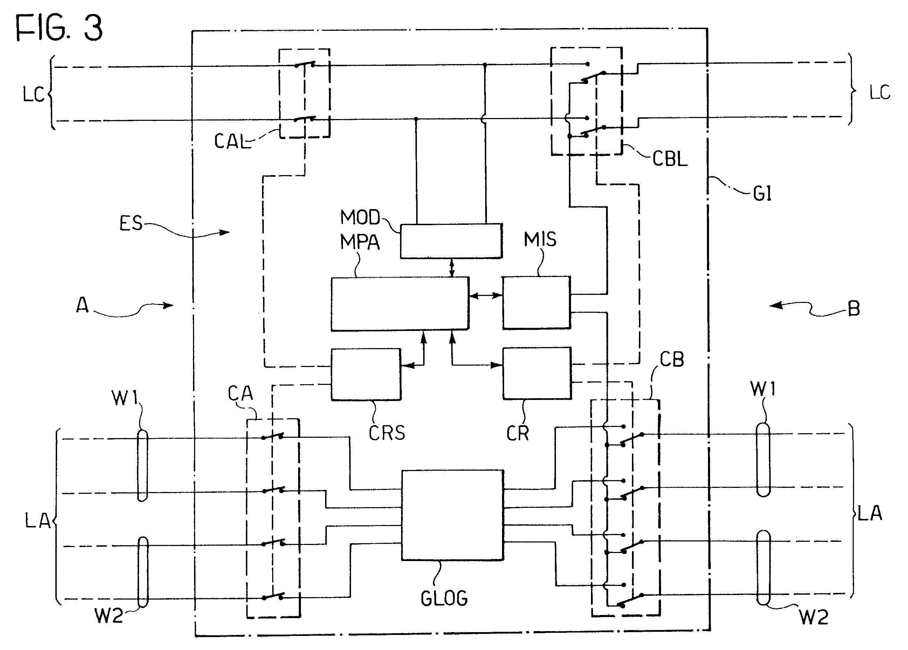

Figure 3 is a block schematic representation of portions of the system according to the invention installed in the sensor boxes;

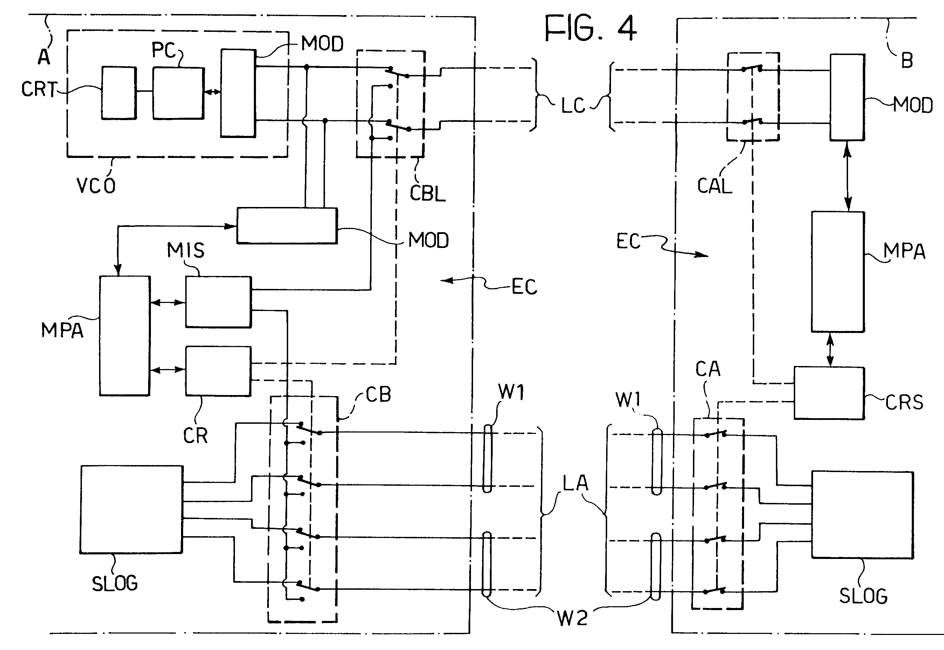

Figure 4 is a block schematic representation of portions of the system according to the invention installed in the stations; and

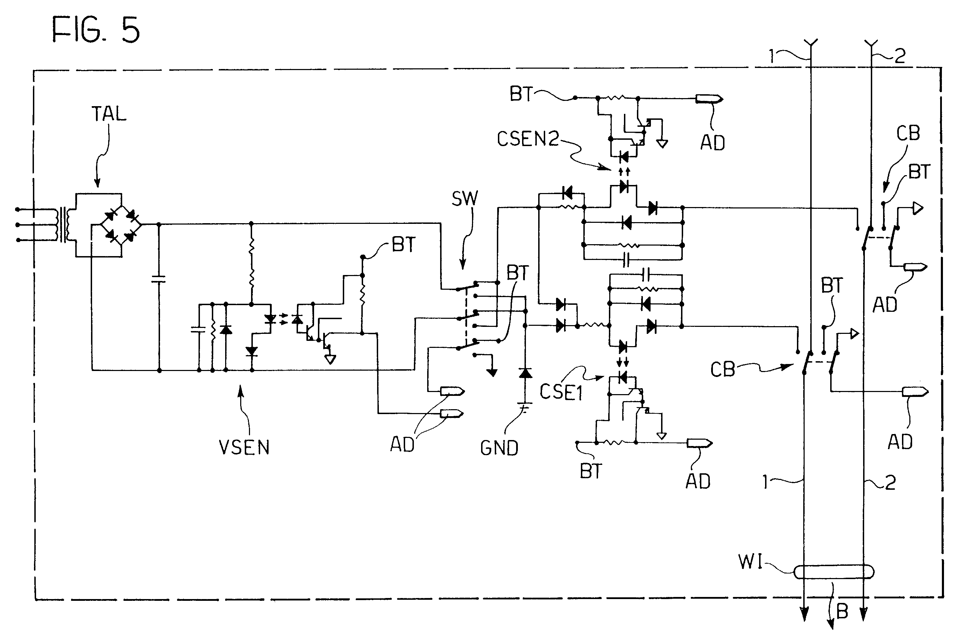

Figures 5, 6, 7 and 8 are schematic circuit representations illustrating the function of a portion of the system according to the invention.

In Figure 2 is schematically shown a railway signalling system substantially similar to that described with reference to Figure 1, provided with a diagnostic system according to the present invention. In Figure 2 the parts and elements already described with reference to Figure 1 have been again allocated the same reference numerals and/or letters.

The system according to the invention includes modules or units EC intended to be installed in the stations A and B, and modules ES intended to be installed in the sensor boxes GI. The modules EC installed in stations A and B and modules ES installed in the sensor boxes GI need to communicate with one another. The modules EC, ES must therefore all be connected to a communication line LC which connects one station to another.

These lines can be already present or can advantageously utilise the relay cables LC present along the section. On the other hand if there are no connections usable for this purpose it is naturally necessary to install a suitable line LC intended for the system. Alternatively it is possible that no physical communication line be used but that the communications between the various modules EC, ES take place via radio.

The modules EC, ES intended to be installed in the stations A and B and in the sensor boxes GT will now be described in detail with reference to Figures 3 and 4.

The heart of each module EC and ES is constituted essentially by an electronic processor or by a microprocessor MPA having analyser functions. Alternative embodiments of the system in question, having different architectures, are naturally possible. Hereinafter, for brevity, reference will be made to the entirety of the processing devices in the modules EC and ES as a microprocessor analyser MPA.

The structure, configuration and programming of this microprocessor analyser MPA will not be further specified in that it is within the scope of the man skilled in the art and clearly derivable from the following description.

Equally, the aspects relating to protocols and communication devices (likewise other possible devices of known type connected to the processors PC, MPA) will not be dealt with in that the techniques and methodologies for their production, configuration and programming are all within the scope of the man skilled in the art.

The microprocessor analyser MPA is connected to a plurality of peripheral devices such as: communication devices, measurement instruments and actuators. More precisely, these peripheral devices, connected to the microprocessor analyser MPA, are of the following types:
- modem MOD which allows the microprocessor analyser MPA to communicate via the communication line LC,
- threshold insulation measurement device MIS which allows the insulation on the relay cables LA to be measured,
- interface device CR, CRS for control of relays CA, CB, CAL, CBL positioned along the relay cables LA at the input to the stations and in the sensor boxes.

It should be mentioned, in fact, that at the inputs to the sensor boxes GI and in the stations A and B there are normally provided input terminal boxes which can be split between the relay cables LA. More specifically, in each generic sensor box GI are provided two sets of relays CA, CB respectively positioned at the inputs of the two sets of relay cables LA entering into the sensor boxes GI. The relays CA are located at the input of the relay cables LA coming from the portion of the line leading to the station A (shown to the left in Figures 2 and 4). The relays CB are connected to the sets of relay cables LA coming from the portion of the line leading to station B (shown to the right in Figures 2 and 4).

This situation can also be generalised at stations A and B. Thus, at station A there is a set of relays CB whilst at station B there is a set of relays CA positioned at the input of the relay cables LA. As far as the system of the present invention is concerned the two stations A and B are not conceptually different from the sensor boxes GI positioned along the line, and can therefore be ideally considered as sensor boxes having a single input of relay cables LA. The differences between the sensor boxes GI and the stations A and B due to their particular details will be indicated hereinafter when it is necessary to distinguish them.

The relay cables LA within the sensor boxes GI or stations A, B are connected to their own circuitry, sensor box circuitry GLOG or station circuitry SLOG, having logic functions and operating at medium voltage. These circuits GLOG, SLOG will not be described further here in that they are of conventional type and known in the art.

Hereinafter will be indicated several differences between a railway signalling system provided with the diagnostic apparatus according to the invention and a signalling system of conventional type. In particular, in the case of the system according to the present invention, the relays CA, that is to say those facing towards the station A, remain of conventional type, that is to say acting as switches or isolators. The relays CB, that is to say those facing towards the station B, are on the other hand replaced by relays acting as diverters.

In the first position the diverters CB connect the relay cables LA to the sensor box circuitry GLOG or station circuitry SLOG, thus permitting normal operation, whilst in a second position they connect the relay cables LA with the above-mentioned threshold insulation measuring device MIS. The relays CB are naturally controlled by the microprocessor analyser MPA via the interface device CR. The relays of CA type, which act only to interrupt the relay cables LA, are also controlled by the microprocessor analyser MPA via an interface device CRS.

Both the interface devices CR and CRS are therefore connected locally to the microprocessor analyser MPA. The threshold insulation measuring device MIS is also controlled by the microprocessor analyser MPA and is thus connected locally to the microprocessor analyser MPA. The microprocessor analyser MPA is further connected, as already mentioned, to a modem MOD so as to be able to communicate remotely via the communication line LC.

It is evident that the architecture as described, that is to say in complete form, is typical of the sensor boxes GI in that they are provided with two sets of relay cables LA at their inputs; at the stations A and B, given their particular details, this architecture is however correspondingly reduced. The station A naturally only has the CB type relays whilst the CA type relays are omitted as is the corresponding interface device CRS. Station B, on the contrary, only has relays of CA type whilst the CB type relays and the corresponding interface device CR are omitted, as is the threshold insulating measuring device MIS.

In one of the two stations, for example the station A, there is further provided an interface device to a human operator, for example the person who controls the station. In a control room VCO of station A there is therefore provided an electronic processor, for example a personal computer PC, provided with a monitor CRT for interface with human beings. This electronic processor PC is also connected, via a modem MOD, to the communication lines LC in such a way that it can communicate with all the microprocessor analysers MPA whether they are in the sensor boxes GI or in the stations A, B. Moreover, the system according to the invention provides, in an embodiment currently considered preferable, the need for a control processor unit having a system management function. This role can be conveniently performed, for example, by the electronic processor PC which, for this reason, will hereinafter be called the central processor.

The operation of the system will now be described. The system is configured in such a way as to be able to perform a series of tests rapidly in a completely automatic manner for identifying faults in the relay cables LA. This series of tests takes place during the course of a diagnostic operation. This diagnostic operation is performed in parallel by all the microprocessor analysers MPA present in the system, and is activated by a diagnosis command typically, if not necessarily, imparted by the central processor PC situated in the control room VCO of the station A. The system diagnosis can be performed periodically, for example at regular intervals, or else can be triggered by a different event, for example a fault detected in a conventional manner. The diagnosis can also be ordered by the station personnel.

To perform a diagnostic operation, therefore, the central processor PC transmits on the communication line LC, a diagnosis activation command, which is simultaneously received by all the microprocessor analysers MPE disposed in the sensor boxes GI and in the stations A, B. Once the said activation command is received the microprocessor analysers MPA activate in such a way as to perform a diagnostic procedure in parallel. This diagnostic procedure involves the performance of the following stages which will now be described.

Each microprocessor analyser MPE commands, via the interface device CRS, the CA type isolator relays to open. The commencement of the execution of this command is controlled immediately afterwards by the microprocessor analyser MPA via the interface device CRS which must naturally be configured in such a way as to allow this to happen. If this test gives a negative result, corresponding to a failure of the relay CA to open, due for example to a fault in the relay CA itself, the microprocessor analyser MPA suspends the diagnostic procedure and memorises information indicative of the fault encountered. Possibly the microprocessor analyser MPA may inform the central processor PC of this occurrence.

Subsequently the microprocessor analyser MPA commands commutation of the relays CB. In this case, too, after the commutation command the microprocessor analyser MPA performs a test to establish, via the interface device CR, that the command has been performed. Commutation of the relays CB, unlike the relays CA, which is controlled in parallel, takes place sequentially. In this way the microprocessor analyser MPA effects an insulation measurement for each of the conductors of the relay cables LA.

This insulation measurement is effected by the threshold insulation measuring device MIS which is from time to time connected, by the commutation of the relays CB, to each of the conductors of the relay cables LA. The insulation measurement takes place by applying a voltage of medium magnitude, for example 500 volts, and measuring the current consumed. Given that the relays CA of subsequent sensor box GI or station B are open, all of the current which is consumed by the conductor segment under measurement results from leakages and/or short circuits. If, therefore, the threshold insulation measurement device MIS detects a current consumption greater than a predetermined threshold value, for example 1 milliampère, this indicates that the insulation of the conductor segment under measurement is insufficient. This information is communicated from the threshold insulation measuring device MIS to the microprocessor analyser MPA which memorises it.

Subsequently the microprocessor analyser MPA proceeds to perform an insulation measurement for each pair W1, W2 of conductors of the relay cables LA. In this case, too, the measurement criteria just described is applied for testing an insufficient insulation between the pair of conductors W1, W2 under measurement. If a fault is detected this condition too is communicated by the threshold insulation measuring device MIS to the microprocessor analyser MPA which memorises it.

A possible circuit embodiment of the threshold insulation measuring device MIS will now be described in more detail with reference to Figures 5, 6, 7 and 8 as well as the circuitry connected to it and the manner in which these insulation measurements are performed. As can be seen, Figures 5, 6, 7 and 8 all represent the same circuit portion, in different operating conditions, so that corresponding parts and elements have been given the same reference numerals and/or letters.

In Figure 5 is shown a circuit portion of the system, which can be equally well in one of the sensor boxes GI or in a station A, substantially comprising the threshold insulation measurement device MIS, a pair of relays CB and a portion of a generic pair of conductors WI of the relay cables LA. In order to be able to distinguish them the conductors of the pair WI have been indicated 1 and 2.

In Figure 5 the circuit is shown in a situation in which the relays CB are commuted to a position such that the conductors 1, 2 of the pair WI of the relay cables LA are not interrupted. In this condition normal operation of the railway signalling system is possible in that continuity of the relay cables LA is insured.

This situation is moreover detectable by the microprocessor analyser MPA. In fact, as can be seen from the drawing, the relays CB are of the double-gang type. One of the gangs, as can be seen, can selectively connect a first segment of one of the conductors 1, 2 (leading to station B) of the pair of relay cables WI to the corresponding segment of conductors 1, 2 (leading to station A) or to the threshold insulation measuring device MIS. The second gang can instead selectively connect a data acquisition terminal AD to two different DC voltage sources. These DC voltage sources are, for example, ground (indicated in the drawing with a triangle) and a low voltage DC voltage source BT, for example a positive voltage of 5V.

The data acquisition terminal AD is connected, via the interface device CR, to the microprocessor analyser MPA. The microprocessor analyser MPA can therefore detect, by testing the logic level present on the terminal AD, the position assumed by the relay CB. Given that the commutation of the relay CB is controlled by the microprocessor analyser MPA, via the interface device CR, the microprocessor analyser MPA is able to detect immediately any possible faults in the relays CB by means of the said data acquisition terminals AD.

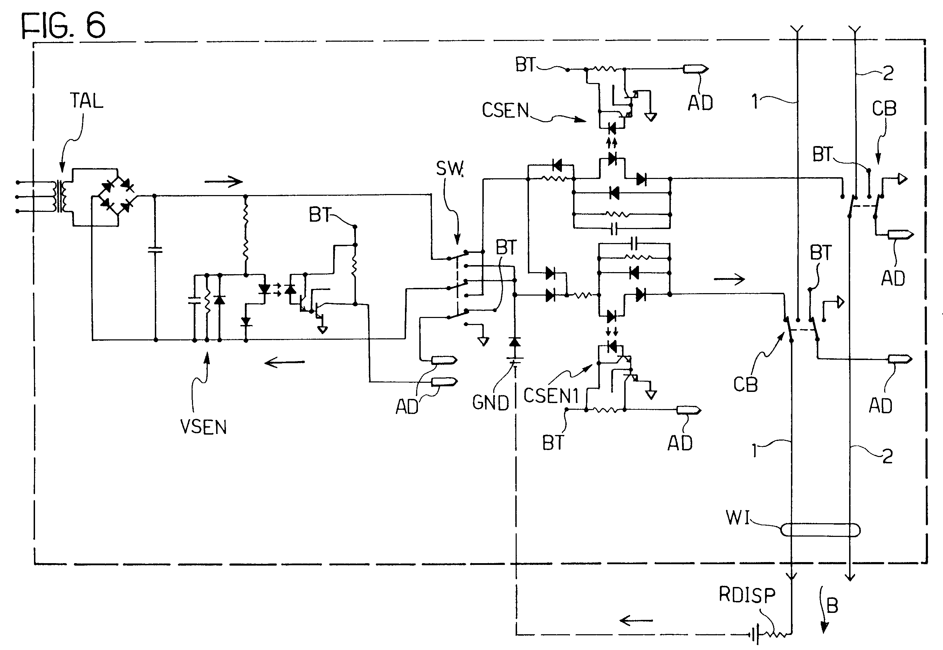

When it is necessary to perform a diagnostic operation the microprocessor analyser MPA commands commutation of the relays CB, commencing, for example, with the relay CB positioned on the conductor 1, to effect the said insulation tests by means of the threshold insulation device MIS. This situation is illustrated in Figure 6 where it can be seen how the conductor 1 is interrupted and its lower portion (represented in the lower part of the drawing facing towards station B) is connected to the threshold insulation measuring device MIS. After having made this switch the microprocessor analyser MPA proceeds, via the threshold insulating measurement device MIS to apply the said measurement voltage, for example 500V, to the portion or segment of conductor 1 being measured. To this end the threshold insulation measurement device MIS is provided with a commutation relay SW. This commutation relay SW acts to connect a supply circuit TAL, operable to produce the measurement voltage of 500V, to the conductors 1, 2. As will be seen, the commutation relay SW is a three-gang relay.

One of three gangs is connected to a data acquisition terminal AD, in a manner entirely similar to the relay CB, to permit the microprocessor analyser MPA to detect the position of the commutation relay SW. The other two gangs serve instead to connect the two terminals of the supply circuit TAL across which the measurement voltage of 500V appears, with the conductors 1, 2 being measured. In particular, in Figure 6 a first (positive) terminal of the supply circuit TAL is connected via the commutation relay SW to the portion of the first conductor 1 of the pair WI being measured, diverted by the relay CB. This connection takes place along the path shown in Figure 6 by a line of increased thickness.

As can be seen this connection takes place via a current measurement circuit CSEN1. This current measurement circuit CSEN1 is connected in parallel to all the relays CB positioned on the first conductor 1 of each pair WI. However, since only one relay CB at a time is switched in such a way as to connect a conductor 1 of one pair WI to the current measurement circuit CSEN1 whilst all the other conductors 1 are disconnected from the current measurement circuit CSEN1, as for example, in the case represented in Figure 5, this does not constitute a problem. The same is true, naturally, for the current measurement circuit CSEN2 and the second conductors 2 of the pairs WI.

The second (negative) terminal of the supply circuit TAL is on the other hand connected, by means of the second gang of the commutation relay SW, to ground, indicated in the drawing with GND. In this case, too, the path along which this connection is made is represented by means of a thicker line. In these conditions a possible leakage to ground GND of the portion of conductor 1 being measured, being represented in the drawing by means of a resistance RDISP, allows current to flow from the positive terminal to the negative terminal of the supply circuit TAL. This current flows along the path represented by lines of greater thickness, and in the direction indicated by the arrows disposed parallel to this path, which is closed via ground GND as represented by the broken line.

The commencement of this current is detected by the current measuring device CSEN1 which is located in the path of the current itself. The current measuring device CSEN1 employs an opto-isolator as a security measure to isolate itself from the measurement voltage of 500V. The measuring device CSEN1 is moreover of the threshold type, that is to say if the current which flows through it exceeds a predetermined value, in the specific case for example one milliampère, it signals this condition by an output of logic type. The first current sensor CSEN1 functions at low voltage BT and is connected to a data acquisition terminal AD of the microprocessor analyser MPA. In this way the microprocessor analyser MPA detects the result of the measurement of insulation to ground GND of the conductor 1 of the pair WI.

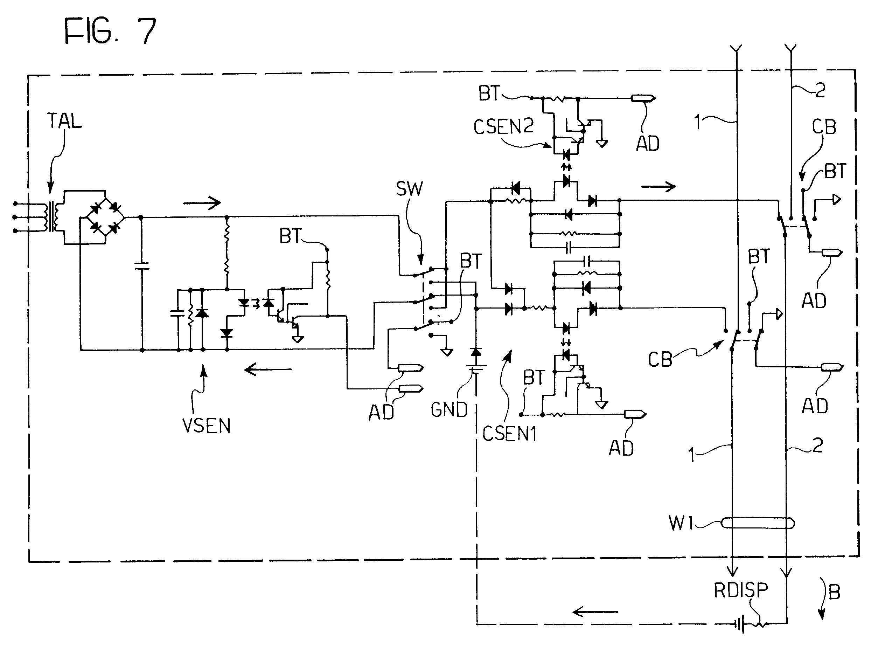

Once the insulation measurement has been performed for the conductor 1 the microprocessor analyser MPA commands the execution of the insulation measurement for the conductor 2. This type of measurement is entirely similar to the measurement effected for the conductor 1, changing only the state of the relay CB and the path of the current. This situation is shown in Figure 7. In this case the relay CB positioned on the conductor 2 is commuted in such a way as to connect it to the threshold insulation measuring device MIS whilst the relay CB on the conductor 1 is returned to its normal position. At this point the positive terminal of the supply circuit TAL is connected to the conductor 2 via the commutation relay SW and the current sensor CSEN2. In this case, too, the path followed by the current is indicated by lines of increased thickness and arrows indicating the direction, and is closed by ground GND as indicated by the broken line. The detection of a possible leakage current greater than the threshold value is effected by the second current sensor CSEN2 which is identical to the first current sensor CSEN1 and is also connected to a data acquisition terminal AD of the microprocessor analyser MPA.

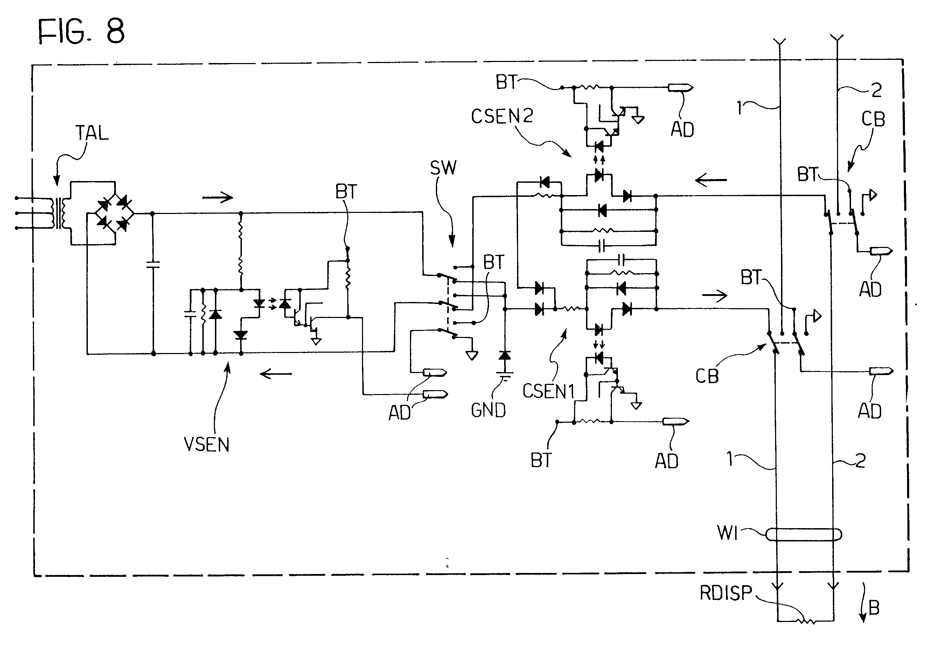

Finally the microprocessor analyser MPA commands execution of an insulation measurement between the two conductors 1, 2 of the pair WI. This situation is illustrated in Figure 8. In this case both the relays CB on the conductors 1, 2 are commuted in such a way as to connect them to the threshold insulation measuring device MIS. More specifically, the first conductor 1 is connected by the current sensor CSEN1 and the first gang of the commutation relay SW to the positive terminal of the supply circuit TAL whilst the second conductor 2 is connected by the second current sensor CSEN2 and the second gang of the commutation relay SW to the negative terminal of the supply circuit TAL. As will be seen, in this case the commutation relay SW is in the opposite state from that of the two preceding cases, shown in Figures 6 and 7. The path of current due to a possible insufficient insulation between the conductors 1, 2 of the pair WI is again indicated by lines of greater thickness and arrows indicating the direction. In this case, however, the current is not closed through ground GND but between the two conductors 1 and 2 of the pair WI by means of a leakage resistance indicated RDISP. It is evident how in this situation the current is detected by the current sensor CSEN1.

The threshold insulation measuring device MIS further includes a voltage sensor VSEN connected across the two terminals of the supply circuit TAL. This voltage sensor VSEN, which also includes an opto-isolator, is substantially similar to the current sensors CSEN1, CSEN2 and is also connected to a data acquisition terminal AD of the microprocessor analyser MPA. By means of the voltage sensor VSEN the microprocessor analyser MPA can therefore control the correct operation of the supply circuit TAL and therefore the effective application of the measurement voltage in the course of the previously described measurement operations.

At the end of the said series of measurements the microprocessor analyser MPA of each sensor box GI and the stations A, B has acquired, for each pair of relay cables WI three units of information (of logic type) that is to say:
- insulation resistance to ground for the first conductor 1,
- insulation resistance to ground for the second conductor 2,
- insulation resistance between the two conductors 1, 2.

The microprocessor analyser MPA is moreover in possession of information relating to the correct (or otherwise) commutation of the relays CA, CB and SW controlled by it, and the operation of the supply circuit TAL.

The sequence of operations, just described, being predetermined, can be performed by any microprocessor analyser MPA within a maximum predetermined time. At the end of this maximum predetermined time the central processor PC of the system acquires from each microprocessor analyser MPA of the system the data stored relating to the tests and measurements performed. This acquisition takes place, naturally, via the communication line LC, for example in a communication mode or protocol known as polling. In this mode, the central processor PC sequentially interrogates all the microprocessor analysers MPA of the system, each of which transmits the stored data to the central processor PC whilst the other microprocessor analysers MPA remain waiting.

It is evident, however, that alternative communication protocols from that illustrated can be utilised. It is moreover also possible that the management role of the system, performed by the central processor PC, may be alternatively performed by another element of the system, for example one of the microprocessor analysers MPA.

If one of the microprocessor analysers MPA had not correctly received the activation command to perform the diagnosis procedure it would signal this situation to the central processor PC during the said data acquisition phase relating to the measurement effected. It is in fact possible that faults or problems of transmission along the communication line LC may also occur.

In an alternative embodiment to the present system the line of communication LC can also be diagnosed as if it were a pair of conductors WI of the relay cables LA. To this end there must naturally be provided relays CAL, CBL situated at the input of the communication line LC in the sensor boxes GI and in the station A, B. These relays CAL, CBL are entirely similar, as far as type and configuration are concerned, to the relays CA and CB described hereinabove and are also controlled by the interface devices CRS and CR respectively.

In this way diagnostic testing of the conductors of the communication line LC can take place in an entirely similar manner to the diagnostic testing of the conductors of the relay cables LA. This is possible because during the course of the diagnostic testing the communication line LC is not utilised so that it is possible to open the relays CAL, CBL and perform insulation measurements which are, naturally, performed also by the threshold insulation measuring device MIS.

As can be noted all the procedures described up to here can be performed in a completely automatic and rapid manner by the microprocessor analysers MPA and by the central processor PC which subsequently informs the personnel in the control room VCO of any possible faults detected during the course of the diagnostic testing operation. In this way a very reduced down time is obtained in that a possible fault is identified with a minimum delay. Moreover, once this first phase of the procedure has been completed, entirely automatically, a repair team can be sent out (from one of the two stations A, B) already in possession of the information relating to the type of fault and to the portion of relay cables LA in which it has happened. The team is therefore able to effect repairs quickly and efficiently.

Naturally, the principle of the invention remaining the same, the details of construction and the embodiments can be widely varied with respect to what has been described and illustrated without by this departing from the ambit of the present invention.

## Claims

1. A system for identifying faults in at least one electrical signalling line (LA) connecting apparatus (GI) disposed along a section of railway line lying between a first station (A) and a second station (B), characterised in that it comprises,
in least one of the said stations (A, B):
- central processor means (PC), in the said stations (A, B) and in the said apparatus (GI):
- peripheral processor means (MPA),
- sensor means (MIS) operatively connected to the said peripheral processor means (MPA), operable to detect electrical quantities in the said line (LA),
- first commutator means (CA, CB) operable to isolate and connect portions of the said line (LA) to the said sensor means (MIS),
and further comprises:
- a communication line (LC) connecting the said central processor means (PC) and the said peripheral processor means (MPA),
the said central processor means (PC) and peripheral processor means (MPA) being configured so as to:
- isolate portions of the said line (LA) by means of the said first commutator means (CA, CB),
- detect a fault in the said portions of the said line (LA) by means of the said sensor means (MIS),
- communicate information relating to the said fault to a human user.

2. A system according to Claim 1, characterised in that the said sensor means include an insulation measurement device (MIS).

3. A system according to Claim 2, characterised in that the said insulation measurement device (MIS) is of the threshold type and is provided with a digital output (AD).

4. A system according to any preceding Claim from 1 to 3, characterised in that it further includes, at the said stations (A, B) and in the said apparatus (GI), supply means (TAL) and second commutator means (SW) operable to supply a test voltage to the said portions of the line (LA) being measured.

5. A system according to Claim 4, characterised in that the said test voltage is a voltage lying between 200V and 1000V.

6. A system according to Claim 5, characterised in that it further includes third commutator means (CAL, CBL) operable to isolate and connect portions of the said communication line (LC) to the said sensor means (MIS) for the purpose of identifying faults in the said communication line (LC) in an identical manner to that which occurs for the said electric line (LA).

7. A system according to any of Claims from 4 to 6 in which the said electric line (LA) comprises a plurality of pairs (WI) of electrical conductors (1, 2) characterised in that the said first (CA, CB) and the said second (SW) commutator means, and the said peripheral processor means (MPA) are configured in such a way as:
- to isolate a portion of a first conductor (1) of a pair of conductors (WI) and measure the insulation to ground (GND) of the said portion of the first conductor (1),
- to isolate a portion of a second conductor (2) of the said pair of conductors (WI) and to measure the insulation to ground (GND) of the said portion of the second conductor (2),
- to isolate the said portions of the first and second conductors (1, 2) of the said pair of conductors (WI) and to measure the mutual insulation of the said portions of the first and second conductors (1, 2), for each of the said plurality of pairs (WI) of electrical conductors.

8. A system according to any of Claims from 2 to 7, characterised in that the said insulation measurement device (MIS) includes at least one current sensor circuit (CSEN1, CSEN2) operable to detect possible leakage currents due to a loss of insulation (RDISP) in the said electrical conductors (1, 2) when isolated and supplied with the said test voltage.

9. A system according to Claim 8, characterised in that the said insulation measurement circuit (MIS) includes a voltage sensor circuit (VSEN) operable to detect the said test voltage.

10. A system according to Claims 8 and 9, characterised in that the said current sensor circuit (CSEN1, CSEN2) and the said voltage sensor circuit (VSEN) employ opto-isolator circuits.

11. A system according to any of Claims from 1 to 10, characterised in that the said central processor means (PC) are configured in such a way as:
- to send, by means of the said communication lines (LC), a diagnostic procedure execution command to each of the said peripheral processor means (MPA),
- said peripheral processor means (MPA) being configured so as:
- to execute the said diagnostic procedure comprising in the said insulation measurement for each of the said pairs (WI) of electrical conductors within a predetermined period of time,
- to memorise the results of the said insulation measurement,
- to transmit the said results to the said central processor means (PC).

12. A system according to Claim 11, characterised in that the said central processor means (PC) are configured in such a way as to sequentially interrogate each of the said peripheral processor means (MPA) subsequent to the said predetermined time period to acquire the said results.

13. A system according to Claim 12, characterised in that the said peripheral processor means (MPA) have associated therewith interface means (CR, CRS) intended to control the said first (CA, CB) and third (CAL, CBL) commutator means and configured in such a way as to permit a test of the commutation state of the said first commutator means (CA, CB) and third commutator means (CAL, CBL),
said peripheral processor means (MPA) being configured so as:
- to perform the said test of the commutation state within the said predetermined time period,
- to memorise the results of the said test,
- to transmit the said results to the said central processor means (PC).

14. A system according to Claim 13, characterised in that the said insulation measurement device (MIS) is configured in such a way as to permit the test of the correct application of the said test voltage to the said electrical conductors (1, 2),
the said peripheral processor means (MPA) being configured so as:
- to perform the said test within the said predetermined time period,
- to memorise the results of the said test,
- to transmit the said results to the said central processor means (PC).

15. A system according to Claim 14, characterised in that the said central processor means (PC) and the said peripheral processor means (MPA) have associated therewith communication means (MOD) operable to allow communication between the said central processor means (PC) and peripheral processor means (MPA) via said communication line (LC).

16. A system according to Claim 15, characterised in that the central processor means (PC) are provided with interface devices (CRT) to human users employed in at least one of the said stations (AB).
